# FASCICULE DE BREVET EUROPEEN

(11) **EP 0 484 259 B1**
(45) Date de publication et mention de la délivrance du brevet: **06.06.2001**
(21) Numéro de dépôt: 91460045.7
(22) Date de dépôt: 30.10.1991
(51) Int. Cl.: H03K 21/40, H03M 7/02, H03M 7/18

(54) **Procédé de codage binaire à taux de basculement des éléments binaires sensiblement uniforme, et procédés d'incrémentation et de décrémentation correspondants**
Binärkodierungsverfahren mit gleichmässiger Umschaltung-Verteilung der binären Elemente und Inkrementierungs-Dekrementierungsverfahren dafür
Binary coding method with uniform switching rate of the binary elements and incrementation/decrementation method therefor

(30) Priorité: 02.11.1990 FR 9013758
(43) Date de publication de la demande: 06.05.1992
(73) Titulaire: FRANCE TELECOM, 75015 Paris (FR)
(72) Inventeur: Burger, Jacques, F-14112 Bieville Beuville (FR); Girault, Marc, F-14000 Caen (FR)
(74) Mandataire: Corlau, Vincent

(56) Documents cités:
- EP-A- 0 092 464
- GB-A- 2 171 543
- GB-A- 2 180 083
- PATENT ABSTRACTS OF JAPAN, vol. 12, no. 196 (E-618)[3043], 7 juin 1988; & JP-A-62 299 116 (SEIKO INSTR. & ELECTRONICS LTD) 26-12-1987

## Description

Le domaine de l'invention est celui du codage binaire, c'est-à-dire de la représentation de données de nature quelconque à l'aide d'éléments binaires 0 ou 1.

L'invention concerne notamment, mais non exclusivement, le codage de données ayant vocation à être représentées séquentiellement, suivant un ordre préétabli.

Plus généralement, l'invention trouve une application privilégiée dans tous les cas où il est nécessaire de coder des données apparaissant, en moyenne, un nombre sensiblement égal de fois.

Un exemple particulier d'application est ainsi le codage d'un compteur, pour lequel les données à coder sont les entiers de 0 à n-1. En ce qui concerne les compteurs, on peut d'ailleurs toujours se ramener à ce cas, puisqu'il suffit pour cela de numéroter de 0 à n-1 les données à représenter dans l'ordre où elles doivent apparaître. L'invention peut s'appliquer aussi bien aux compteurs simples, systématiquement incrémentés, qu'aux compteurs susceptibles d'être tantôt incrémentés, tantôt décrémentés.

L'invention peut notamment être utilisée dans le cas où on met en oeuvre des mémoires de type sensible à l'usure. C'est par exemple le cas des mémoires E2PROM (Electrically Erasable Programmable Read-Only Memory) (Mémoire morte programmable effaçable électriquement), telles que celles contenues dans les cartes à micro-processeur.

Toutefois, il est clair que l'invention peut s'appliquer au codage de tout type de données, quel que soit le système d'information et/ou de traitement de données et les supports de mémorisation utilisés.

On connaît déjà de nombreux procédés de codage binaire des nombres entiers. Le procédé le plus utilisé est la représentation de cet entier par sa décomposition binaire en base 2, souvent nommé codage binaire classique ou codage binaire naturel. Un autre procédé bien connu consiste à représenter chaque chiffre de la décomposition en base 10 de cet entier par la décomposition en base 2 de ce chiffre. Il faut alors 4 éléments binaires pour coder chaque chiffre de la décomposition en base 10. Il existe encore plusieurs types de codages binaires, correspondant à des applications ou des besoins spécifiques.

Ainsi, dans certaines applications, il est souhaitable que le procédé de codage utilisé soit tel que, lorsque l'on passe d'un entier à l'entier suivant, ou à l'entier précédent, le nombre d'éléments binaires qui basculent, c'est-à-dire qui changent de valeur, soit aussi faible que possible en moyenne, l'idéal étant 1. Le codage binaire classique est loin de cet idéal, puisque la moyenne de basculement est environ égale à 2.

En ce qui concerne cette contrainte de basculement minimal, des solutions satisfaisantes existent depuis longtemps. Ces solutions sont connues sous le nom de codes à changement minimal (en anglais : minimum-change codes), et sont décrites par exemple dans le document suivant : "Data Transmission" (Transmission des données), W.R. BENNETT & J.R. DAVEY, New York, Mc Graw-Hill, 1965. Les codes de Gray constituent un exemple particulier des codes à changement minimal. Ils sont notamment décrits dans le document de brevet américain publié le 17 mars 1953 sous le numéro 2 632 058.

Les codes de Gray s'avèrent particulièrement intéressants et sont très employés, en raison de la simplicité de leur construction, de la simplicité des conversions entre ces codes et le code binaire classique, et du fait que le nombre d'éléments binaires utilisés est égal au nombre d'éléments binaires utilisés dans le codage binaire classique, lequel nombre est le plus petit possible.

Cependant, il est parfois également souhaitable que les éléments binaires basculent, en moyenne, tous autant les uns que les autres, autrement dit que le basculement soit uniforme. Le codage de Gray n'a pas cette propriété, puisque l'élément binaire de poids faible bascule un nombre de fois environ égal à la moitié du nombre d'entiers à coder à chaque parcours d'un compteur, tandis que l'élément binaire de poids fort ne bascule qu'une fois.

La contrainte de basculement uniforme des éléments binaires se pose par exemple de façon cruciale dans le cas des mémoires du type E2PROM. En effet, dans ces mémoires, le nombre de basculements possibles pour chaque élément binaire étant limité, par exemple de l'ordre de quelques milliers, il est avantageux de répartir de façon homogène les basculements entre tous les éléments binaires, ce qui permet d'allonger la durée de vie des composants.

Il n'existe pas de codage réellement efficace vis à vis de cette contrainte particulière.

On connait, du document GB-A-2 171 543, une techique particulière visant à distribuer de façon homogène le nombre de basculements dans des unités de comptage de poids faibles. Cependant, il ne s'agit que d'une répartition homogène entre des compteurs, et non entre unités discrètes binaires constituant chacun de ces compteurs.

L'invention a notamment pour objectif de pallier cet inconvénient.

Plus précisément, l'invention a pour objectif de fournir un procédé de codage binaire de données numériques induisant un taux de basculement moyen uniforme, ou sensiblement uniforme, pour chacun des éléments binaires.

Un objectif complémentaire de l'invention est de fournir un tel procédé de codage, induisant un nombre minimal, c'est-à-dire proche de ou égal à 1, de basculements d'éléments binaires lors du passage d'une valeur à son successeur et/ou à son prédécesseur.

Ainsi, dans le cas d'un compteur, l'invention a notamment pour objectif de fournir un tel procédé de codage, selon lequel le nombre de basculements qu'a subi l'élément binaire le plus basculé, lorsque le compteur a été parcouru une fois ou un nombre entier de fois, est peu supérieur au nombre minimal possible, c'est-à-dire, pour chaque tour de compteur, au nombre d'entiers à coder divisé par le nombre d'éléments binaires utilisés.

En d'autres termes, un des objectifs de l'invention est de fournir un procédé de codage satisfaisant, de façon pratiquement optimale, les deux contraintes de basculement minimal et de basculement uniforme.

Un autre objectif de l'invention est de fournir un tel procédé de codage, utilisant un nombre d'éléments binaires égal, ou peu supérieur dans une variante de l'invention, au nombre minimal possible, c'est-à-dire le nombre d'éléments binaires utilisés dans le codage binaire classique. Cette caractéristique s'avère essentielle notamment lorsque le système utilisé est limité en place mémoire.

Un objectif particulier de l'invention est de fournir un tel procédé de codage, utilisable pour le codage de données dans des mémoires de type sensible à l'usure, tel que les E2PROM, dans des applications telles que les cartes à microprocesseur. Dans ce cas, l'invention permet de maximiser la durée de vie des mémoires.

Selon une première variante, l'invention a pour objectif de fournir un tel procédé de codage, à nombre de basculements encore plus réduit, au prix d'une légère augmentation du nombre d'éléments binaires.

Selon une autre variante, l'invention a pour objectif de fournir un tel procédé de codage, plus spécifiquement destiné aux suites de données destinées à être parcourues plusieurs fois.

De façon complémentaire, l'invention a également pour objectif de fournir des procédés d'incrémentation et de décrémentation d'une suite de données ne nécessitant pas un décodage complet de la donnée initiale.

Un autre objectif de l'invention est de fournir de tels procédés de codage, d'incrémentation et de décrémentation ne nécessitant pas de calculs complexes, et mettant en oeuvre des moyens logiques élémentaires, tant dans un but de simplification que de rapidité.

Ces objectifs, ainsi que d'autres qui apparaîtront par la suite, sont atteints selon l'invention à l'aide d'un procédé de codage binaire de données numériques, dans lequel lesdites données sont codées sur deux champs distincts d'éléments binaires, un champ de référence et un champ de permutation, la séquence d'éléments binaires affectée audit champ de permutation subissant une permutation fonction de la valeur contenue dans ledit champ de référence.

Ces permutations permettent de faire varier, dans le champ de permutation, la position des éléments binaires basculant beaucoup avec celle des éléments basculant peu, de façon à homogénéiser en moyenne les basculements sur l'ensemble du champ.

Dans un mode de réalisation avantageux de l'invention, ladite permutation est une rotation dont l'amplitude est fonction de la valeur contenue dans ledit champ de référence.

Cela permet notamment une mise en oeuvre simple de l'invention, à l'aide de techniques connues de rotation de suites binaires.

De façon préférentielle, ladite permutation est calculée de façon à assurer un taux moyen de basculement sensiblement uniforme pour chacun des éléments binaires constitutifs dudit champ de permutation.

Ainsi, par exemple, une rotation régulière du champ de permutation, en fonction de l'évolution d'un compteur, permet d'affecter successivement à chaque élément binaire physique du champ tous les éléments binaires logiques, de celui basculant le plus souvent à celui basculant le moins souvent. On obtient donc, en moyenne, un taux de basculement sensiblement uniforme pour chacun des éléments binaires physiques.

En revanche, la contrainte de basculement uniforme n'est pas nécessairement respectée dans le champ de permutation. Cela s'avère toutefois peu important, les éléments binaires de ce champ basculant très rarement, par rapport à ceux du champ de permutation.

Dans le cas d'un tel procédé appliqué au codage de n données distinctes, lesdits champs de référence et de permutation comprenant respectivement q et r éléments binaires, le nombre total d'éléments binaires (q+r) est préférentiellement égal ou supérieur au nombre d'éléments binaires nécessaires au codage desdites n données distinctes selon le code binaire naturel.

Le procédé selon l'invention ne nécessite en effet pas plus d'éléments binaires que le codage binaire classique, c'est-à-dire le minimum. Toutefois, dans certaines variantes, il peut être intéressant d'utiliser un nombre plus important d'éléments binaires, ainsi qu'on le verra par la suite.

Il est par ailleurs avantageux de respecter l'égalité r = 2^{q}, ou au moins l'inégalité r ≤ 2^{q}.

La taille du champ de référence est choisie de façon qu'il ne soit pas trop grand, la propriété de basculement uniforme n'ayant lieu que dans le champ de permutation.

Avantageusement, le codage d'une valeur N comprend les étapes suivantes:
- détermination des valeurs Q et R correspondant respectivement au quotient et au reste de la division euclidienne de ladite valeur N par le nombre n_{R} de valeurs distinctes qu'il est possible de coder dans ledit champ de permutation;
- affectation audit champ de référence d'une première séquence d'éléments binaires, correspondant à ladite valeur Q, selon une première logique de codage;
- affectation audit champ de permutation d'une seconde séquence d'éléments binaires, correspondant à ladite valeur R, selon une seconde logique de codage;
- permutation dépendant de ladite valeur Q, de ladite seconde séquence d'éléments binaires dans ledit champ de permutation.

Dans un mode de réalisation particulièrement simple et efficace de l'invention, ladite permutation est une rotation d'amplitude Q, ou plus généralement d'amplitude A_{Q} fonction de la valeur Q.

L'invention s'avère notamment avantageuse dans le cas où lesdites données numériques à coder forment une suite finie de valeurs évoluant séquentiellement.

En effet, dans ce cas, on peut obtenir un taux de basculement uniforme à chaque parcours de la suite, ou, ainsi qu'on le verra plus loin, lorsque la suite a été parcourue un nombre fixé de fois.

Préférentiellement, au moins la seconde logique de codage induit le basculement d'un nombre minimal d'éléments binaires dans le champ correspondant, lors du passage d'une desdites données à la donnée suivante et/ou précédente.

Il peut par exemple s'agir d'un code de Gray.

Ainsi, l'invention répond simultanément aux deux contraintes de basculement uniforme et minimal.

Dans une variante de l'invention, ladite seconde logique de codage comprend les étapes suivantes :
- association d'une séquence d'éléments binaires à ladite valeur R ;
- concaténation à ladite séquence d'éléments binaires d'au moins un élément binaire de valeur fixe.

De cette façon, le taux de basculement de chaque élément binaire est encore réduit. En effet, le ou les éléments binaires de valeurs fixes sont successivement affectés à chaque emplacement du champ de permutation. Tant que le champ de référence n'évolue pas, cet emplacement ne voit donc aucun basculement. En revanche, ce procédé de codage nécessite plus d'éléments binaires physiques que le codage binaire naturel.

Selon une autre variante de l'invention, du type appliqué au codage d'une suite de données destinée à être parcourue plusieurs fois, ledit champ de référence contient une séquence d'éléments binaires correspondant au nombre de parcours de ladite suite effectués, et en ce que ledit champ de permutation contient une séquence d'éléments binaires correspondant à la donnée courante de ladite suite.

Dans ce dernier cas, le procédé peut avantageusement comprendre une étape de remise à zéro et/ou d'interruption de ladite suite, effectuant l'incrémentation de la valeur contenue dans ledit champ de référence, et l'affectation audit champ de permutation de la séquence d'éléments binaires correspondant à la première donnée de ladite suite.

Le procédé de codage de l'invention n'impose pas, pour passer d'une valeur à la suivante, ou à celle qui précède, de décoder l'entier initial, puis de recoder le successeur ou le prédécesseur selon les principes décrits.

En effet, l'invention concerne également un procédé d'incrémentation d'une suite de données codées selon le procédé décrit ci-dessus, comprenant les étapes suivantes :
- détermination de ladite valeur Q contenue dans ledit champ de référence, selon ladite première logique de codage ;
- réalisation d'une permutation de décodage dépendant de ladite valeur Q, de ladite séquence d'éléments binaires contenue dans ledit champ de permutation, inverse de la permutation de codage ;
- incrémentation selon ladite seconde logique de codage de la séquence d'éléments binaires obtenue après ladite permutation ;
- si la valeur, selon ladite seconde logique de codage de la séquence d'éléments binaires incrémentée correspond à la première donnée de ladite suite, incrémentation selon ladite première logique de codage de la séquence d'éléments binaires contenue dans ledit champ de référence et détermination de la valeur Q correspondant ;
- réalisation d'une permutation de décodage dépendant de ladite valeur Q, de ladite séquence d'éléments binaires incrémentée contenue dans ledit champ de permutation.

De façon symétrique, l'invention présente un procédé de décrémentation d'une suite de données codées selon le procédé précédemment décrit, comprenant étapes suivantes :
- détermination de la valeur Q contenue dans ledit champ de référence, selon ladite première logique de codage ;
- réalisation d'une permutation de décodage dépendant de ladite valeur Q, de ladite séquence d'éléments binaires contenue dans ledit champ de permutation, inverse de la permutation de codage ;
- décrémentation selon ladite seconde logique de codage de la séquence d'éléments binaires obtenue après ladite permutation ;
- si la valeur selon ladite seconde logique de codage de la séquence d'éléments binaires décrémentée correspond à la dernière donnée de ladite suite, décrémentation selon ladite première logique de codage de la séquence d'éléments binaires contenue dans ledit champ de référence, et détermination de la valeur Q correspondant ;
- réalisation d'une permutation de codage dépendant de ladite valeur Q, de ladite séquence d'éléments binaires décrémentée contenue dans ledit champ de permutation.

D'autres caractéristiques et avantages de l'invention apparaîtront à la lecture de la description suivante d'un mode de réalisation préférentiel de l'invention, donné à titre illustratif et non limitatif, et des dessins annexés, dans lesquels :
- la figure 1 présente le principe de base de l'invention, reposant sur la décomposition du codage en deux champs distincts, et la réalisation de permutation sur l'un de ces champs ;
- la figure 2 est un schéma illustrant une méthode de codage d'une valeur selon le principe présenté en figure 1 ;
- la figure 3 illustre un procédé d'incrémentation d'une suite de données codées selon la méthode de la figure 2.

Le procédé de codage selon l'invention a notamment pour but de réduire le nombre moyen de basculements de chaque élément binaire d'un code en répartissant de façon homogène les basculements sur chacun des éléments binaires.

Pour cela, on utilise tout d'abord un code classique, avantageusement du type des codes à changement minimal, puis l'on effectue des permutations sur la valeur obtenue, en fonction d'une valeur de référence.

Dans le mode de réalisation décrit, ces permutations sont des rotations. Toutefois, il apparaît clairement que tout type de permutation peut être utilisé, dès lors qu'il assure une répartition moyenne homogène des basculements.

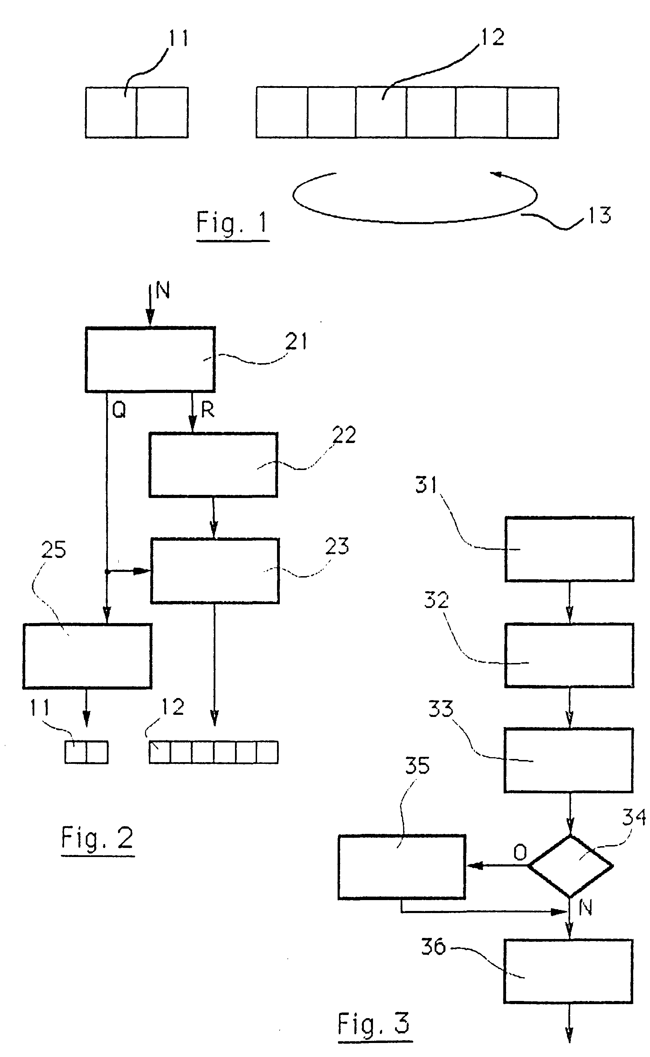

La figure 1 illustre le principe de l'invention.

Le codage d'une valeur s'effectue sur deux champs distincts, un champ de référence 11 et un champ de permutation 12. Ainsi qu'on le verra par la suite, la contrainte de basculement uniforme n'est vérifiée que pour le champ de permutation 12. Cela ne tire toutefois pas à conséquence, les éléments binaires du champ de référence 11 n'étant destinés à varier que très rarement.

De façon simplifiée, le codage a lieu en trois temps. On détermine tout d'abord la valeur à coder dans le champ de référence 11, puis la valeur à coder dans le champ de permutation 12. Enfin, on effectue une rotation 13 du champ de permutation 12, dont l'amplitude est fonction de la valeur contenue dans le champ de référence 11. C'est l'application de ces rotations qui assure l'uniformité des basculements.

La figure 2 présente un mode de codage selon l'invention.

On considère le codage d'un entier N. On procède tout d'abord à la division euclidienne 21 de l'entier N par le nombre n_{R} de valeurs distinctes qu'il est possible de coder dans le champ de permutation. On obtient ainsi deux valeurs Q et R, correspondant au quotient et au reste de la division (N = Q.n_{R} + R).

La valeur R est codée, dans un module de codage 22, selon une logique de codage choisie, telle que, par exemple, un codage de Gray. La séquence binaire obtenue subit alors une rotation 23, dont l'amplitude est fonction de la valeur Q. Dans un mode de réalisation particulier, plus précisément décrit par la suite, cette rotation 23 est d'amplitude Q. Toutefois, il apparaît clairement que de nombreuses autres fonctions associant une amplitude A_{Q} à la valeur Q peuvent être utilisées, et fournissent un résultat équivalent. La séquence binaire obtenue après rotation est affectée au champ de permutation 12.

De même, la valeur Q est codée, dans un module de codage 25, selon une seconde logique de codage, puis affectée au champ de référence 11.

Il est à noter que les deux logiques de codage peuvent être de tout type connu. Elles peuvent être identiques ou non. Avantageusement, au moins pour le champ de permutation, on choisit un code à changement minimal.

Avant de décrire plus particulièrement un mode de réalisation particulier de l'invention, mettant en oeuvre le codage de Gray, on rappelle rapidement le principe de ce codage.

### . Codage de Gray :

On donne ci-dessous une définition des codes de Gray, des procédés de conversion entre codage de Gray et codage binaire classique, ainsi qu'un procédé d'incrémentation et de décrémentation. D'autres définitions et procédés existent, qui sont équivalents à ceux-ci.

On se limite ici aux codes de Gray sur s bits, notés G_{S}, où s est un entier positif. On note OUX l'opération OU Exclusif bit à bit.

Le code de Gray sur s bits, noté Gₛ, est la fonction qui, à tout entier compris entre 0 et 2^{s}-1, et de décomposition en base 2 égale à hₛhₛ₋₁....h₁ associe l'entier dont la décomposition en base 2 est le champ d'éléments binaires gₛgₛ₋₁....g₁ défini par :
gₛ = hₛ
gₛ₋₁ = hₛ₋₁ OUX hₛ
gₛ₋₂ = hₛ₋₂ OUX hₛ₋₁
...
g₁ = h₁ OUX h₂

La fonction inverse (décodage de Gray sur s bits) est alors la fonction qui, au champ gₛgₛ₋₁....g₁, associe le champ hₛhₛ₋₁....h₁ défini par :
hₛ = gₛ
hₛ₋₁ = gₛ₋₁ OUX gₛ
hₛ₋₂ = gₛ₋₂ OUX gₛ₋₁ OUX gₛ
h₁ = g₁ OUX g₂ OUX ... OUX gₛ

La fonction incrémentation d'un code Gray sur s bits, noté Incrₛ, est la fonction qui, au codage G(x) = gₛgₛ₋₁....g₁ d'un entier x compris entre 0: et 2^{s}-1, associe le codage G(x+1) de l'entier succédant à x, étant entendu que x+1 désigne l'entier 0 dans le cas où x = 2^{s}-1. La fonction Incrₛ obéit à la règle suivante :

Si g₁ OUX g₂ OUX ... OUX gₛ = 0, alors basculer g₁.

Sinon, et si g₁ = 1, alors basculer g₂.
Sinon, et si g₂ = 1, alors basculer g₃.
....Sinon, et si gₛ₋₂ = 1, alors basculer gₛ₋₁.
Sinon, basculer gₛ.

La fonction décrémentation d'un code Gray sur s bits, noté Decrₛ, est la fonction qui, au codage G(x) = gₛgₛ₋₁....g₁ d'un entier x compris entre 0 et 2^{s}-1, associe le codage G(x-1) de l'entier précédant x, étant entendu que x-1 désigne l'entier 2^{s}-1 dans le cas où x = 0. La fonction Decrₛ obéit à la règle suivante :

Si g₁ OUX g₂ OUX ... OUX gₛ = 1, alors basculer g₁.
Sinon, et si g₁ = 1, alors basculer g₂.
Sinon, et si g₂ = 1, alors basculer g₃.
....Sinon, et si gₛ₋₂ = 1, alors basculer gₛ₋₁.
Sinon, basculer gₛ.

### . Exemple de codage d'un compteur :

Soit X = {0, 1, 2, ..., n-1} un intervalle de n nombres entiers appelé compteur, et destiné à être parcouru séquentiellement une ou plusieurs fois. Dans ce dernier cas, 0 sera considéré comme le successeur de n-1.

Le mode de réalisation décrit ci-dessous concerne le cas où n une est puissance de 2 (n = 2^{k}). On peut toutefois toujours se ramener à ce cas, en remplaçant n par le plus petit entier de la forme 2^{k} qui lui soit supérieur ou égal.

Chaque entier x est codé à l'aide d'un champ C(x) de k éléments binaires (comme dans le cas du codage binaire classique), appelé code ou codage de x. Ce champ est subdivisé en deux sous-champs : un champ dit de référence, constitué de q bits, et un champ dit de permutation, constitué de r bits, et situé à droite du champ de référence, ainsi que cela est présenté en figure 1. On a donc : k = q+r.

Dans une utilisation avantageuse de cette invention, on a l'égalité r = 2^{q}. On a alors : k = 2^{q}+q. Ainsi, lorsque q = 1,2,3,4,5,... alors k = 3,6,11,20,37,... et n = 8,64,2048,2²⁰,2³⁷... De manière générale, il est avantageux de choisir q petit et tel que 2^{q}≥k-q.

On notera que si la valeur q doit être faible, il n'est pas forcément bon de choisir le plus faible possible. Il est en effet facile de construire des exemples où la valeur la plus faible n'est pas la meilleure. Par exemple, si q+r = 36, l'uniformité est mieux assurée en prenant q = 6 que q = 5.

On note G_{S} la fonction qui, à un entier compris entre 0 et 2^{S}-1, associe son code de Gray sur s bits, Incr_{S} (respectivement Decr_{S}) la fonction incrémentation (respectivement décrémentation) d'un code de Gray sur s bits, c'est-à-dire la fonction qui, au codage de Gray d'un entier compris entre 0 et 2^{S}-1, associe le codage de Gray de son successeur (respectivement de son prédécesseur), telles que définies ci-dessus.

On note C_{q} une fonction de codage quelconque qui, à un entier compris entre 0 et 2^{q}-1, associe un champ de q bits et réciproquement. Ainsi, C_{q} peut être le codage binaire classique sur q bits, ou encore, C_{q} peut être le codage de Gray sur q bits G_{q}.

Le compteur est divisé en 2^{q} intervalles Iⱼ de longueur égale. Cette longueur vaut 2^{r}.

Pour coder un élément x de I₀, qui est l'intervalle des entiers compris entre 0 et 2^{r}-1, le champ de référence est pris égal à C_{q}(0) et le champ de permutation égal à Gᵣ(x).

Pour coder un élément x de I₁, qui est l'intervalle des entiers compris entre 2^{r} et 2.2^{r}-1, le champ de référence est pris égal à C_{q}(1) et le champ de permutation égal à Gᵣ(x-2^{r}).

On notera que le codage binaire classique de x-2^{r} n'est rien d'autre que le champ constitué des r bits de poids faible du codage binaire classique de x. Puis, on applique une rotation à gauche d'amplitude 1 au champ de permutation, c'est-à-dire que, si le champ de permutation était égal à "gᵣgᵣ₋₁...g₁" avant la rotation, il devient "gᵣ₋₁...g₁gᵣ" après la rotation.

Plus généralement, pour coder un élément x de Iⱼ, le champ de référence est pris égal à C_{q}(j) et le champ de permutation égal à Gᵣ(x-j.2^{r}). Le codage binaire classique de x-j.2^{r} n'est donc rien d'autre que le champ constitué des r bits du codage binaire classique de x. Puis on applique une rotation à gauche d'amplitude j au champ de permutation, c'est-à-dire que, si le champ de permutation était égal à "gᵣgᵣ₋₁...g₁" avant la rotation, il devient "gᵣ₋ⱼ...g₁gᵣ...gᵣ₋ⱼ₊₁" après la rotation. Dans le cas où j est supérieur ou égal à r, on remplacera au préalable j par le reste de la division de j par r.

Dans le cas où C_{q} est le codage binaire classique sur q bits, alors le procédé de conversion entre le codage binaire classique et le codage qui vient d'être défini est particulièrement simple. Il suffit en effet de conserver les q bits de poids fort du codage binaire classique de x (ces q bits sont égaux au codage binaire classique de j), de transformer les r bits restants par un codage de Gray Gᵣ, puis d'appliquer une rotation à gauche d'amplitude j sur le champ de permutation.

Une autre possibilité avantageuse consiste à prendre pour C_{q} le codage de Gray G_{q}.

A titre d'exemple, on présente le cas où n = 64, k =6 et q = 2, et où C₂ est le codage binaire classique sur 2 bits. Soit h₆h₅h₄h₃h₂h₁ la décomposition binaire d'un entier x, j l'entier dont la décomposition binaire est h₆h₅, x' l'entier dont la décomposition binaire est h₄h₃h₂h₁. Le champ de référence est alors pris égal à h₆h₅. Le champ de permutation est obtenu en appliquant une rotation à gauche d'amplitude j à G(x').

On obtient alors le tableau 1 suivant :

**TABLEAU 1**

| x | codage binaire classique | codage selon l'invention |
|---|---|---|
| 0 | 000000 | 000000 |
| 1 | 000001 | 000001 |
| 2 | 000010 | 000011 |
| . | . | . |
| . | . | . |
| . | . | . |
| 15 | 001111 | 001000 |
| 16 | 010000 | 010000 |
| 17 | 010001 | 010010 |
| 18 | 010010 | 010110 |
| . | . | . |
| . | . | . |
| . | . | . |
| 31 | 011111 | 010001 |
| 32 | 100000 | 100000 |
| 33 | 100001 | 100100 |
| 34 | 100010 | 101100 |
| . | . | . |
| . | . | . |
| . | . | . |
| 62 | 111110 | 111100 |
| 63 | 111111 | 110100 |

Pour décoder un entier codé par le procédé qui vient d'être décrit, on commence par effectuer un décodage du champ de référence, ce qui fournit un entier j. Ensuite, on applique une rotation à droite de longueur j au champ de permutation. Enfin, on effectue un décodage de Gray sur r bits du champ de permutation, ce qui fournit un entier x'. L'entier recherché est alors égal à x'+j.2^{r}.

En considérant l'exemple ci-dessus (tableau 1), et si l'on désire décoder le code constitué des bits '101000', on commence par décoder le champ de référence, égal à '10', ce qui fournit j = 2. on applique alors une rotation à droite de longueur 2 au champ de permutation, égal à '1000', ce qui donne '0010'. On décode alors ce champ selon un code de Gray sur 4 bits, ce qui fournit y = 3. L'entier codé par le champ de comptage initial était donc 3 + 2.2⁴ = 35. La décomposition binaire classique h₆h₅h₄h₃h₂h₁ de cet entier est obtenue en conservant les deux bits de poids fort, soit '10', et en appliquant une conversion du code de Gray vers le code binaire classique au champ '0010', ce qui donne '0011', soit au total '100011'.

Selon ce procédé, on vérifie bien que, lorsque l'on passe d'un entier à l'entier qui le succède, un seul élément binaire change de valeur dans le champ de permutation. Exceptionnellement, un élément binaire change également dans le champ de référence. De plus, lorsque le compteur a été entièrement parcouru, les éléments binaires du champ de permutation ont basculé à peu près autant de fois les uns que les autres. Les éléments du champ de référence ont, eux, basculé très peu de fois.

### Incrémentation du compteur

Pour passer du code d'un entier au code de l'entier successeur, autrement dit pour incrémenter le compteur, il n'est pas nécessaire ni même souhaitable de décoder l'entier initial puis de coder l'entier successeur. Il suffit en effet d'appliquer la méthode suivante, présenté en ralation avec la figure 3.

Tout d'abord, on effectue le décodage 31 de la valeur Q contenue dans le champ de référence. On réalise ensuite une rotation 32 d'amplitude A_{Q}, fonction de la valeur Q, de la séquence binaire contenue dans le champ de permutation, dans le sens contraire au sens du codage. Ainsi, on obtient, dans le champ de permutation, la séquence codée correspondant à la valeur R, qu'il n'est pas nécessaire de décoder.

En effet, il suffit d'incrémenter (33) cette séquence, selon la logique de codage choisie pour le champ de permutation. Deux cas se présentent alors, selon que le test 34 indique que la nouvelle valeur R correspondant à la séquence incrémentée est nulle ou non.

Si R est non nul, il suffit de pratiquer une nouvelle rotation 36 d'amplitude A_{Q} sur cette séquence, dans le sens du codage, pour obtenir la séquence à affecter au champ de permutation. Le champ de référence reste inchangé.

En revanche, si la valeur R est devenue égale à 0, il faut alors effectuer l'incrémentation 35 de la valeur Q, selon la logique de codage utilisée pour le champ de référence. Ensuite, on pratique une rotation 36 du champ de référence, d'amplitude A_{Q} fonction de la nouvelle valeur Q.

Il apparaît clairement que la méthode d'incrémentation fonctionne de façon équivalente lorsque les rotations sont remplacées par des permutations quelconques. De même, il est à noter que les logiques de codage utilisées pour les deux champs peuvent être quelconques, identiques ou non.

Dans l'exemple de codage décrit précédemment, la rotation a une amplitude Q. Le procédé d'incrémentation est alors plus précisément le suivant.

On commence par décoder le champ de référence, ce qui fournit un entier j, puis on applique une rotation à droite d'amplitude j au champ de permutation dont les bits deviennent gᵣ...g₁. ensuite, on applique la fonction Incrᵣ (décrite précédemment) à ce champ. Enfin, on applique une rotation à gauche d'amplitude j au champ de permutation. De plus, si la fonction Incrᵣ a eu pour effet de basculer gᵣ de 1 à 0, alors on incrémente le champ de référence et on applique une rotation supplémentaire à gauche d'amplitude 1 au champ de permutation. L'incrémentation du champ de référence n'est pas décrite ici, puisqu'elle dépend du codage C_{q} utilisé.

### Décrémentation du compteur

Le principe de décrémentation d'un compteur est symétrique à celui de l'incrémentation. On ne le précise ici que dans le cas particulier correspondant au mode de réalisation décrit en détail.

On commence par décoder le champ de référence, ce qui fournit un entier j, puis on applique une rotation à droite d'amplitude j au champ de permutation, dont les bits deviennent gᵣ...g₁. Ensuite, on applique la fonction Decrᵣ à ce champ. Enfin on applique une rotation à gauche d'amplitude j au champ de permutation. De plus, si la fonction Decrᵣ a eu pour effet de basculer gᵣ de 0 à 1, alors on décrémente le champ de référence et on applique une rotation supplémentaire à droite d'amplitude 1 au champ de permutation. La décrémentation du champ de référence n'est pas décrite ici, puisqu'elle dépend du codage C_{q} utilisé.

### Première variante de l'invention

Dans une première variante de l'invention, on augmente légèrement le nombre total de bits du code de façon à diminuer encore le nombre de basculements dans le champ de permutation.

Cette variation est décrite ci-dessous dans le cas où n est une puissance de 2(n=2^{k}). On peut toujours se ramener à ce cas, en remplaçant n par le plus petit entier de la forme 2^{k} qui lui soit supérieur ou égal.

Chaque entier x est codé à l'aide d'un champ C(x) de k+p éléments binaires, appelé code ou codage de x. Ce champ est subdivisé en deux sous-champs: un champ dit de référence, constitué de q bits, et un champ dit de permutation, constitué de p+r bits, et situé à droite du champ de référence. On a donc : k=q+r.

Dans une utilisation avantageuse de cette invention, on a l'égalité p+r=2^{q}. On a alors : k=2^{q}+q-p. Ainsi, lorsque q=3 et p=1, k=10 et n=1024. On notera que lorsque p=0, on retrouve l'invention de base.

Les deux caractéristiques essentielles de cette variante sont les mêmes que pour l'invention de base, le taux de basculement étant toutefois plus faible. Les notations sont également les mêmes.

Le compteur est divisé en 2^{q} intervalles Iⱼ de longueur égale. Cette longeur vaut 2^{r}.

Pour coder un élément x de I₀, qui est l'intervalle des entiers compris entre 0 et 2^{r}-1, le champ de référence est pris égal à C_{q}(0) et le champ de permutation égal à 0ₚ| | Gᵣ(x) où 0ₚ désigne un champ de p bits tous égaux à 0, et où | | est le symbole de concaténation de champs d'éléments binaires.

Plus généralement, on peut remplacer 0ₚ par une configuration fixe quelconque de bits.

Pour coder un élément x de I₁, qui est l'intervalle des entiers compris entre 2^{r} et 2.2^{r}-1, le champ de référence est pris égal à C_{q}(1) et le champ de permutation égal à 0ₚ| | Gᵣ(x-2^{r}). Puis on applique une rotation à gauche d'amplitude 1 au champ de permutation, c'est-à-dire que, si le champ de permutation était égal à "gᵣ₊ₚgᵣ₊ₚ₋₁...g₁" avant la rotation, il devient "gᵣ₊ₚ₋₁...g₁gᵣ₊ₚ" après la rotation.

Plus généralement, pour coder un élément x de Iⱼ, le champ de référence est pris égal à C_{q}(j) et le champ de permutation égal à 0ₚ | | Gᵣ(x-j.2^{r}). Puis on applique une rotation à gauche d'amplitude j au champ de permutation, c'est-à-dire, que si le champ de permutation était égal à "gᵣ₊ₚgᵣ₊ₚ₋₁...g₁" avant la rotation, il devient "gᵣ₊ₚ₋ⱼ...g₁gᵣ₊ₚ...gᵣ₊ₚ₋ⱼ₊₁" après la rotation. Dans le cas où j est supérieur ou égal à p+r, on remplace au préalable j par le reste de la division de j par p+r.

Dans le cas où C_{q} est le codage binaire classique sur q bits, alors le procédé de conversion entre le codage binaire classique et le codage qui vient d'être défini est particulièrement simple. Il suffit en effet de conserver les q bits de poids fort du codage binaire classique de x (ces q bits sont égaux au codage binaire classique de j), de transformer les r bits restants par un codage de Gray Gᵣ, de faire précéder les r bits résultants de p bits égaux à 0, puis d'appliquer une rotation à gauche d'amplitude j sur ce champ de p+r bits.

Un autre choix avantageux consiste à prendre pour C_{q} le codage de Gray G_{q}.

A titre d'exemple, on présente le cas où n=16, k=4, q=2 et p=2, et où C₂ est le codage binaire classique sur 2 bits. Soit h₄h₃h₂h₁ la décomposition binaire d'un entier x, j l'entier dont la décomposition binaire est h₄h₃, x' l'entier dont la décomposition binaire est h₂h₁. Le champ de référence est alors pris égal à h₄h₃. Le champ de permutation est obtenu en appliquant une rotation à gauche d'amplitude j à G(x'), précédé de deux bits '0'.

On obtient donc le tableau suivant :

**TABLEAU 2**

| x | codage binaire classique | codage selon la première variante |
|---|---|---|
| 0 | 0000 | 000000 |
| 1 | 0001 | 000001 |
| 2 | 0010 | 000011 |
| 3 | 0011 | 000010 |
| 4 | 0100 | 010000 |
| 5 | 0101 | 010010 |
| 6 | 0110 | 010110 |
| 7 | 0111 | 010100 |
| 8 | 1000 | 100000 |
| 9 | 1001 | 100100 |
| 10 | 1010 | 101100 |
| 11 | 1011 | 101000 |
| 12 | 1100 | 110000 |
| 13 | 1101 | 111000 |
| 14 | 1110 | 111001 |
| 15 | 1111 | 110001 |

Pour décoder un entier codé par le procédé qui vient d'être décrit, on commence par effectuer un décodage du champ de référence, ce qui fournit un entier j. Ensuite, on applique une rotation à droite de longueur j au champ de permutation. Enfin, on effectue un décodage de Gray sur les r bits de poids faible du champ de permutation, ce qui fournit un entier x'. L'entier recherché est alors égal à x'+j.2^{r}.

Reprenant l'exemple ci-dessus, et si l'on désire décoder le code constitué des bits '101000', on commence par décoder le champ de référence, égal à '10', ce qui fournit j=2. On applique alors une rotation à droite de longueur 2 au champ de permutation, égal à '1000', ce qui donne '0010'. On décode alors le sous-champ '10' selon un code de Gray sur 2 bits, ce qui fournit y=3. L'entier codé par le champ de comptage initial était donc 3+2.2²=11. La décomposition binaire classique h₄h₃h₂h₁ de cet entier est obtenue en conservant les deux bits de poids fort, soit '10', et en appliquant une conversion du code de Gray vers le code binaire classique au champ '10', ce qui donne '11', soit au total '1011'.

Les procédés d'incrémentation et de décrémentation décrits précédemment s'appliquent également à cette première variante.

### Seconde variante de l'invention

La seconde variante présentée de l'invention s'applique plus particulièrement au cas où on code un compteur destiné à être parcouru plusieurs fois, avec éventuellement possibilité d'interruption à chaque parcours.

Cette variante est ci-dessous décrite dans le cas où n est une puissance de 2 (n=2^{r}). On peut toujours se ramener à ce cas, en remplaçant n par le plus petit entier de la forme 2r qui lui soit supérieur ou égal.

Chaque entier x est codé à l'aide d'un champ C(x) de r+q éléments binaires, appelé code ou codage de x. Ce champ est subdivisé en deux sous-champs: un champ dit de référence, constitué de q bits, et un champ de permutation, constitué de r bits, et situé à droite du champ de référence.

Dans une utilisation avantageuse de cette invention, on a l'égalité r=2^{q}. Ainsi, lorsque q=1,2,3,4,5,.. alors r=2,4,8,16,32,... et n=4,16,256,16384,2³²,...

Les deux caractéristiques essentielles de cette variation sont les mêmes que pour l'invention de base. Les notations sont également les mêmes. On appelle x l'entier à coder.

Lorsque le compteur est parcouru pour la première fois, le champ de référence est pris égal à C_{q}(0) et le champ de permutation égal à Gᵣ(x).

Lorsque le compteur est parcouru pour la seconde fois, le champ de référence est pris égal à C_{q}(1) et le champ de permutation égal à Gᵣ(x). Puis, on applique une rotation à gauche d'amplitude 1 au champ de permutation, c'est-à-dire que, si le champ de permutation était égal à "gᵣgᵣ₋₁...g₁" avant la rotation, il devient "gᵣ₋₁...g₁gᵣ" après la rotation.

Plus généralement, lorsque le compteur est parcouru pour la (j+1)-ème fois, le champ de référence est pris égal à C_{q}(j) (dans le cas où j est supérieur ou égal à r, on remplacera au préalable j par le reste de la division de j par r) et le champ de permutation égal à Gᵣ(x). Puis, on applique une rotation à gauche d'amplitude j au champ de permutation, c'est-à-dire que, si le champ de permutation était égal à "gᵣgᵣ₋₁...g₁" avant la rotation, il devient "gᵣ₋ⱼ...g₁gᵣ...gᵣ₋ⱼ₊₁" après la rotation.

A titre d'exemple, on présente le cas où n=16, r=4 et q=2 et où C₂ est le codage binaire classique sur 2 bits. On obtient donc le tableau suivant :

**TABLEAU 3**

| | x | codage binaire classique | codage selon la seconde variante |
|---|---|---|---|
| Premier parcous | 0 | 0000 | 000000 |
| | 1 | 0001 | 000001 |
| | 2 | 0010 | 000011 |
| | . | . | . |
| | . | . | . |
| | . | . | . |
| | 15 | 1111 | 001000 |
| Second parcours | 0 | 0000 | 010000 |
| | 1 | 0001 | 010010 |
| | 2 | 0010 | 010110 |
| | . | . | . |
| | . | . | . |
| | . | . | . |
| | 15 | 1111 | 010001 |
| Troisième parcours | 0 | 0000 | 100000 |
| | 1 | 0001 | 100100 |
| | 2 | 0010 | 101100 |
| | . | . | . |
| | . | . | . |
| Quatrième parcours | . | . | . |
| | 14 | 1110 | 111100 |
| | 15 | 1111 | 110100 |

Pour décoder un entier codé par le procédé qui vient d'être décrit, on commence par effectuer un décodage du champ de référence, ce qui fournit un entier j. Ensuite, on applique une rotation à droite d'amplitude j au champ de permutation. Enfin, on effectue un décodage de Gray sur k bits du champ de permutation, ce qui fournit l'entier x.

Reprenant l'exemple ci-dessus, et si l'on désire décoder le code constitué des bits '101000', on commence par décoder le champ de référence, égal à '10', ce qui fournit j=2. On applique alors une rotation à droite d'amplitude 2 au champ de permutation, égal à '1000', ce qui donne '0010'. on décode alors ce champ selon un code de Gray sur 4 bits, ce qui fournit x=3. L'entier codé par le champ de comptage initial était donc 3.

Ainsi, dans cette seconde variante, la valeur contenue dans le champ de permutation correspond directement à la valeur du compteur, et la valeur contenue dans le champ de référence contient le nombre de parcours effectués de ce compteur.

Si l'on désire interrompre un parcours donné et/ou remettre le compteur à zéro, alors on incrémente le champ de référence, et tous les bits du champ de permutation sont pris égaux à 0.

Les procédés d'incrémentation et de décrémentation décrits peuvent s'appliquer à cette seconde variante de l'invention.

## Revendications

1. Procédé de codage binaire dans un système d'information et/ou de traitement de données, d'une donnée numérique N appartenant à un ensemble de données numériques distinctes, et dans lequel ladite donnée numérique N est codée sur deux champs formant un champ de référence et un champ de permutation respectivement associés à une première valeur Q et une seconde valeur R permettant de reconstruire ladite donnée numérique, lesdites valeurs Q et R étant respectivement égales au quotient et au reste de la division euclidienne de l'entier N par le nombre n_{R} de valeurs distinctes qu'il est possible de coder dans le champ de permutation (N = Q.n_{R} + R), ledit procédé comprenant les étapes suivantes :
(a) attribution à la première valeur Q d'une première séquence d'éléments binaires selon une première logique de codage et affectation de cette première séquence d'éléments binaires à un premier champ de stockage d'éléments binaires (11) constituant ledit champ de référence,
(b) attribution à la seconde valeur R d'une seconde séquence d'éléments binaires selon une seconde logique de codage et affectation de cette seconde séquence d'éléments binaires à un second champ de stockage d'éléments binaires (12) constituant ledit champ de permutation,
(c) exécution de permutations, dépendant de ladite première valeur Q, des éléments binaires formant ladite seconde séquence, selon une règle de permutation choisie de façon que tous les éléments binaires formant ledit champ de permutation présentent un taux de basculement moyen sensiblement homogène.

2. Procédé selon la revendication 1, caractérisé en ce que ladite permutation (23) est une rotation d'amplitude AQ fonction de ladite valeur Q.

3. Procédé selon la revendication 3, caractérisé en ce que ladite rotation (23) est une rotation d'amplitude Q.

4. Procédé selon l'une quelconque des revendications 1 à 3, caractérisé en ce que lesdits champs de référence (11) et de permutation (12) comprennent respectivement q et r éléments binaires, respectant simultanément les conditions suivantes :
- le nombre total d'éléments binaires (q+r) est égal ou supérieur au nombre d'éléments binaires nécessaires au codage desdites n données selon le code binaire naturel ;
- ladite valeur r est inférieure ou égale à 2^{q}.

5. Procédé selon l'une quelconque des revendications 1 à 4, caractérisé en ce que lesdites données numériques à coder forment une suite finie de valeurs évoluant séquentiellement.

6. Procédé selon la revendication 5, caractérisé en ce qu'au moins ladite seconde logique de codage induit le basculement d'un nombre minimal d'éléments binaires dans un champ correspondant, lors du passage d'une desdites données à la donnée suivante et/ou précédente.

7. Procédé selon la revendication 6, caractérisé en ce qu'au moins ladite seconde logique de codage correspond à un codage de Gray.

8. Procédé selon l'une quelconque des revendications 1 à 7, caractérisé en ce que ladite seconde logique de codage comprend les étapes suivantes ;
- association d'une séquence d'éléments binaires à ladite valeur R ;
- concaténation à ladite séquence d'éléments binaires d'au moins un élément binaire de valeur fixe.

9. Procédé selon l'une quelconque des revendications 1 à 8, du type appliqué au codage d'une suite de données destinée à être parcourue plusieurs fois, caractérisé en ce que ledit champ de référence (11) contient une séquence d'éléments binaires correspondant au nombre de parcours de ladite suite effectués, en ce que ledit champ de permutation (12) contient une séquence d'éléments binaires correspondant à la donnée courante de ladite suite, et en ce qu'il comprend une étape de remise à zéro et/ou d'interruption de ladite suite, effectuant l'incrémentation de la valeur contenue dans ledit champ de référence (11), et l'affectation audit champ de permutation (12) de la séquence d'éléments binaires correspondant à la première donnée de ladite suite.

10. Procédé d'incrémentation d'une donnée numérique N appartenant à un ensemble de n données numériques distinctes, codée selon le procédé de codage binaire de l'une quelconque des revendications 1 à 9, comprenant les étapes suivantes :
(a) attribution à la première valeur Q d'une première séquence d'éléments binaires selon une première logique de codage et affectation de cette première séquence d'éléments binaires à un premier champ de stockage d'éléments binaires (11) constituant ledit champ de référence,
(b) attribution à la seconde valeur R d'une seconde séquence d'éléments binaires selon une seconde logique de codage et affectation de cette seconde séquence d'éléments binaires à un second champ de stockage d'éléments binaires (12) constituant ledit champ de permutation,
(c) exécution de permutations, dépendant de ladite première valeur Q, des éléments binaires formant ladite seconde séquence, selon une règle de permutation choisie de façon que tous les éléments binaires formant ledit champ de permutation présentent un taux de basculement moyen sensiblement homogène,
ledit procédé d'incrémentation comprenant les étapes suivantes :
- détermination (31) de ladite valeur Q contenue dans ledit champ de référence (11), selon ladite première logique de codage ;
- réalisation (32) d'une permutation de décodage dépendant de ladite valeur Q, de ladite séquence d'éléments binaires contenue dans ledit champ de permutation (12), inverse de la permutation de codage ;
- incrémentation (33) selon ladite seconde logique de codage de la séquence d'éléments binaires obtenue après ladite permutation ;
- si la valeur, selon ladite seconde logique de codage, de la séquence d'éléménts binaires incrémentée correspond à la première donnée de ladite suite (34), incrémentation (35) selon ladite première logique de codage de la séquence d'éléments binaires contenue dans ledit champ de référence (11) et détermination de la valeur Q correspondant ;
- réalisation (36) d'une permutation de codage dépendant de ladite valeur Q, de ladite séquence d'éléments binaires incrémentée contenue dans ledit champ de permutation (12).

11. Procédé de décrémentation d'une donnée numérique N appartenant à un ensemble de n données numériques distinctes, codée selon le procédé de codage binaire de l'une quelconque des revendications 1 à 10, comprenant les étapes suivantes :
(a) attribution à la première valeur Q d'une première séquence d'éléments binaires selon une première logique de codage et affectation de cette première séquence d'éléments binaires à un premier champ de stockage d'éléments binaires (11) constituant ledit champ de référence,
(b) attribution à la seconde valeur R d'une seconde séquence d'éléments binaires selon une seconde logique de codage et affectation de cette seconde séquence d'éléments binaires à un second champ de stockage d'éléments binaires (12) constituant ledit champ de permutation,
(c) exécution de permutations, dépendant de ladite première valeur Q, des éléments binaires formant ladite seconde séquence, selon une règle de permutation choisie de façon que tous les éléments binaires formant ledit champ de permutation présentent un taux de basculement moyen sensiblement homogène,
ledit procédé de décrémentation comprenant les étapes suivantes;
- détermination de la valeur Q contenue dans ledit champ de référence, selon ladite première logique de codage ;
- réalisation d'une permutation de décodage dépendant de ladite valeur Q, de ladite séquence d'éléments binaires contenue dans ledit champ de permutation, inverse de la permutation de codage ;
- décrémentation selon ladite seconde logique de codage de la séquence d'éléments binaires obtenue après ladite permutation ;
- si la valeur selon ladite seconde logique de codage de la séquence d'éléments binaires décrémentée correspond à la dernière donnée de ladite suite, décrémentation selon ladite première logique de codage de la séquence d'éléments binaires contenue dans ledit champ de référence, et détermination de la valeur Q correspondant ;
- réalisation d'une permutation de codage dépendant de ladite valeur Q, de ladite séquence d'éléments binaires décrémentée contenue dans ledit champ de permutation.

## Patentansprüche

1. Binärkodierungsverfahren eines digitalen Wertes N in einem Informations- und/oder Datenverarbeitungssystem, derzu einer Menge untereinander verschiedener digitaler Werte gehört und wobei dieser digitale Wert N über zwei Felder kodiert wird, die jeweils ein Referenzfeld und ein Permutationsfeld bilden, welche jeweils einem ersten Wert Q und einem zweiten Wert R zugeordnet sind, welche das Wiederherstellen des digitalen Wertes ermöglichen, wobei die Werte Q und R jeweils gleich dem Quotienten und dem Rest der euklidischen Division der ganzen Zahl N durch die Zahl n_{R} der verschiedenen, im Permutationsfeld ( N = Q n_{R} + R) kodierbaren Werte sind und wobei das Verfahren die folgenden Schritte umfaßt:
(a) Zuordnen einer ersten Folge von Binärelementen zu dem ersten Wert Q, nach einer ersten Kodierlogik und Zuordnen dieser ersten Folge von Binärelementen zu einem ersten Feld für das Speichern binärer Elemente (11), welches das Referenzfeld bildet,
(b) Zuordnen einer zweiten Folge von Binärelementen zu dem zweiten Wert R, nach einer zweiten Kodierlogik und Zuordnen dieser zweiten Folge von Binärelementen zu einem zweiten Feld für das Speichern der Binärelemente (12), welches das bereits erwähnte Permutationsfeld bildet,
(c) Ausführen von Permutationen in Abhängigkeit des ersten Wertes Q, wobei Binärelemente die zweite Folge bilden, nach einer Permutationsregel, die derart gewählt wird, daß alle Binärelemente, die das Permutationsfeld bilden, eine in etwa homogene durchschnittliche Umschaltrate aufweisen.

2. Verfahren nach Anspruch 1,
dadurch gekennzeichnet, daß die Permutation (23) eine Rotation der Amplitude A_{Q} als Funktion des Wertes Q ist.

3. Verfahren nach Anspruch 3,
dadurch gekennzeichnet, daß die Rotation (23) eine Rotation mit der Amplitude Q ist.

4. Verfahren nach einem der Ansprüche 1 bis 3,
dadurch gekennzeichnet, daß die Referenzfelder (11) und die Permutationsfelder (12) jeweils q bzw. r Binärelemente umfassen, die gleichzeitig die folgenden Bedingungen erfüllen:
- die Gesamtzahl binärer Elemente (q + r) ist gleich oder größer als die erforderliche Zahl an Binärelementen für das Kodieren der n Daten nach dem natürlichen Binärcode;
- der Wert r ist kleiner oder gleich 2^{q}.

5. Verfahren nach einem der Ansprüche 1 bis 4,
dadurch gekennzeichnet, daß die zu kodierenden numerischen Daten eine unendliche Folge von Werten bilden, die sich sequentiell ändern.

6. Verfahren nach Anspruch 5,
dadurch gekennzeichnet, daß zumindest die zweite Kodierlogik das Umschalten einer minimalen Zahl von Binärelementen in einem entsprechenden Feld beim Übergang von einem dieser Datenwerte zum nachfolgenden und/oder zum vorhergehenden bewirkt.

7. Verfahren nach Anspruch 6,
dadurch gekennzeichnet, daß zumindest die zweite Kodierlogik einer Gray-Kodierung entspricht.

8. Verfahren nach einem der Ansprüche 1 bis 7,
dadurch gekennzeichnet, daß die zweite Kodierlogik die folgenden Schritte umfaßt:
- Zuordnung einer Folge von Binärelementen zum Wert R,
- Verkettung von mindestens einem Binärelement mit festem Wert zur Folge von Binärelementen.

9. Verfahren nach einem der Ansprüche 1 bis 8, von der Art, die für das Kodieren einer Datenfolge angewandt wird, die mehrere Male durchlaufen werden soll,
dadurch gekennzeichnet, daß das Referenzfeld (11) eine Folge von Binärelementen umfaßt, die der Zahl der Durchläufe dieser Folge entspricht,
daß das Permutationsfeld (12) eine Folge von Binärelementen umfaßt, die dem laufenden Datenwert dieser Folge entsprechen, und
daß es ferner einen Schritt zur Rückstellung auf Null und/oder zum Unterbrechen dieser Folge umfaßt, wobei dieser Schritt das Inkrementieren des im Referenzfeld (11) enthaltenen Wertes und das Zuordnen der Folge von Binärelementen, die dem ersten Datenwert dieser Folge entsprechen, zum Permutationsfeld (12) bewirkt.

10. Verfahren zum Inkrementieren eines digitalen Wertes N aus einer Menge von n untereinander verschiedenen digitalen Daten, die nach dem binären Kodierungsverfahren nach einem der Ansprüche 1 bis 9 kodiert sind und die folgenden Schritte umfaßt:
(a) Zuordnen einer ersten Folge von Binärelementen zu dem ersten Wert Q nach einer ersten Kodierlogik und Zuordnen dieser ersten Folge von Binärelementen zu einem ersten Feld für das Speichern von Binärelementen (11), welches das bereits erwähnte Referenzfeld bildet,
(b) Zuordnen einer zweiten Folge von Binärelementen zu dem zweiten Wert R, nach einer zweiten Kodierlogik und Zuordnen dieser zweiten Folge von Binärelementen zu einem zweiten Feld für das Speichern der Binärelemente (12), welches das bereits erwähnte Permutationsfeld bildet,
(c) Ausführen von Permutationen in Abhängigkeit des ersten Wertes Q, wobei Binärelemente die zweite Folge bilden, nach einer Permutationsregel, die derart gewählt wird, daß alle Binärelemente, die das Permutationsfeld bilden, eine in etwa homogene durchschnittliche Umschaltrate aufweisen,
wobei das Inkrementierungsverfahren die folgenden Schritte umfaßt:
- Bestimmen (31) des im Referenzfeld (11) enthaltenen Wertes Q nach der ersten Kodierlogik;
- Ausführen (32) einer vom Wert Q und von der im Permutationsfeld (12) enthaltenen Folge von Binärelementen abhängigen Dekodierpermutation, die umgekehrt zur Kodierungspermutation verläuft;
- Inkrementieren (33) der nach dieser Permutation erhaltenen Folge von Binärelementen gemäß der zweiten Kodierlogik;
- wenn der Wert der nach der zweiten Kodierlogik inkrementierten Folge von Binärelementen dem ersten Datenwert der Folge (34) entspricht, dann erfolgt das Inkrementieren (35) nach der ersten Kodierlogik der im Referenzfeld (11) enthaltenen Folge von Binärelementen und die Festlegung des entsprechenden Wertes Q;
- Ausführen (36), in Abhängigkeit des Wertes Q, einer Kodierpermutation der im Permutationsfeld (12) enthaltenen inkrementierten Folge von Binärelementen.

11. Dekrementierungsverfahren eines digitalen Wertes N, der zu einer Menge von n untereinander verschiedenen digitalen Werten gehört und nach dem binären Kodierverfahren eines der Ansprüche 1 bis 10 kodiert ist, mit den folgenden Schritten:
(a) Zuordnen einer ersten Folge von Binärelementen zu dem ersten Wert Q, nach einer ersten Kodierlogik und Zuordnen dieser ersten Folge von Binärelementen zu einem ersten Feld für das Speichern von Binärelementen (11), welches das Referenzfeld bildet,
(b) Zuordnen einer zweiten Folge von Binärelementen zu dem zweiten Wert R, nach einer zweiten Kodierlogik und Zuordnen dieser zweiten Folge von Binärelementen zu einem zweiten Feld für das Speichern der Binärelemente (12), welches das Permutationsfeld bildet,
(c) Ausführen von Permutationen in Abhängigkeit des ersten Wertes Q, wobei Binärelemente die zweite Folge bilden, nach einer Permutationsregel, die derart gewählt wird, daß alle Binärelemente, die das Permutationsfeld bilden, eine in etwa homogene durchschnittliche Umschaltrate aufweisen,
wobei das Dekrementierungsverfahren die folgenden Schritte umfaßt:
- Bestimmen des im Referenzfeld enthaltenen Wertes Q, nach der ersten Kodierlogik;
- Ausführen einer vom Wert Q und von der im Permutationsfeld enthaltenen Folge von Binärelementen abhängigen Dekodierpermutation, welche umgekehrt zur Kodierungspermutation verläuft;
- Dekrementieren der nach dieser Permutation erhaltenen Folge von Binärelementen gemäß der zweiten Kodierlogik;
- wenn der Wert der nach der zweiten Kodierlogik dekrementierten Folge von Binärelementen dem letzten Datenwert der Folge entspricht, dann erfolgt das Dekrementieren nach der ersten Kodierlogik der im Referenzfeld enthaltenen Folge von Binärelementen und die Festlegung des entsprechenden Wertes Q;
- Ausführen, in Abhängigkeit des Wertes Q, einer Kodierpermutation der im Permutationsfeld enthaltenen dekrementierten Folge von Binärelementen.

## Claims

1. Process for the binary coding in an information system and/or data processing system, of a digital datum N belonging to a set of distinct digital data, and in which the said digital datum N is coded on two fields forming a reference field and a permutation field respectively associated with a first value Q and a second value R making it possible to reconstruct the said digital datum, the said values Q and R being respectively equal to the quotient and to the remainder of the Euclidean division of the integer N by the number n_{R} of distinct values which it is possible to code in the permutation field (N = Q.n_{R} + R), the said process comprising the following steps:
(a) allocation to the first value Q of a first sequence of binary elements according to a first coding logic and assignment of this first sequence of binary elements to a first field for storing binary elements (11) constituting the said reference field,
(b) allocation to the second value R of a second sequence of binary elements according to a second coding logic and assignment of this second sequence of binary elements to a second field for storing binary elements (12) constituting the said permutation field,
(c) execution of permutations, depending on the said first value Q, of the binary elements forming the said second sequence, according to a permutation rule chosen in such a way that all the binary elements forming the said permutation field exhibit a substantially homogenous mean toggling rate.

2. Process according to Claim 1, characterized in that the said permutation (23) is a rotation of amplitude A_{Q} dependent on the said value Q.

3. Process according to Claim 3, characterized in that the said rotation (23) is a rotation of amplitude Q.

4. Process according to any one of Claims 1 to 3, characterized in that the said reference field (11) and permutation field (12) respectively comprise q and r binary elements, simultaneously complying with the following conditions:
- the total number of binary elements (q + r) is equal to or greater than the number of binary elements required for coding the said n data according to the natural binary code;
- said value r is less than or equal to 2^{q}.

5. Process according to any one of Claims 1 to 4, characterized in that the said digital data to be coded form a sequentially-changing finite string of values.

6. Process according to Claim 5, characterized in that at least the said second coding logic induces the toggling of a minimum number of binary elements in a corresponding field, on passing from one of the said data to the succeeding and/or preceding datum.

7. Process according to Claim 6, characterized in that at least the said second coding logic corresponds to a Gray coding.

8. Process according to any one of Claims 1 to 7, characterized in that the said second coding logic comprises the following steps:
- association of a sequence of binary elements with the said value R;
- concatenation with the said sequence of binary elements of at least one binary element of fixed value.

9. Process according to any one of Claims 1 to 8, of the type applied to the coding of a data string intended to be traversed several times, characterized in that the said reference field (11) contains a sequence of binary elements corresponding to the number of traversals of the said string which are performed, in that the said permutation field (12) contains a sequence of binary elements corresponding to the current datum of the said string,
and in that it comprises a step of re-zeroing and/or of interruption of the said string, performing the incrementation of the value contained in the said reference field (11), and the assigning to the said permutation field (12) of the sequence of binary elements corresponding to the first datum of the said string.

10. Process for incrementing a digital datum N belonging to a set of n distinct digital data, the datum being coded according to the binary coding process of any one of Claims 1 to 9, comprising the following steps:
(a) allocation to the first value Q of a first sequence of binary elements according to a first coding logic and assignment of this first sequence of binary elements to a first field for storing binary elements (11) constituting the said reference field,
(b) allocation to the second value R of a second sequence of binary elements according to a second coding logic and assignment of this second sequence of binary elements to a second field for storing binary elements (12) constituting the said permutation field,
(c) execution of permutations, depending on the said first value Q, of the binary elements forming the said second sequence, according to a permutation rule chosen in such a way that all the binary elements forming the said permutation field exhibit a substantially homogenous mean toggling rate,
the said incrementation process comprising the following steps:
- determination (31) of the said value Q contained in the said reference field (11), according to the said first coding logic;
- carrying out (32) of a decoding permutation dependent on the said value Q, of the said sequence of binary elements which is contained in the said permutation field (12), which is the inverse of the coding permutation;
- incrementation (33) according to the said second coding logic of the sequence of binary elements which is obtained after the said permutation;
- if the value, according to the said second coding logic, of the incremented sequence of binary elements corresponds to the first datum of the said string (34), incrementation (35) according to the said first coding logic of the sequence of binary elements which is contained in the said reference field (11) and determination of the corresponding value Q;
- carrying out (36) of a coding permutation dependent on the said value Q, of the said incremented sequence of binary elements which is contained in the said permutation field (12) .

11. Process for decrementing a digital datum N belonging to a set of n distinct digital data, the datum being coded according to the binary coding process of any one of Claims 1 to 10, comprising the following steps:
(a) allocation to the first value Q of a first sequence of binary elements according to a first coding logic and assignment of this first sequence of binary elements to a first field for storing binary elements (11) constituting the said reference field,
(b) allocation to the second value R of a second sequence of binary elements according to a second coding logic and assignment of this second sequence of binary elements to a second field for storing binary elements (12) constituting the said permutation field,
(c) execution of permutations, depending on the said first value Q, of the binary elements forming the said second sequence, according to a permutation rule chosen in such a way that all the binary elements forming the said permutation field exhibit a substantially homogenous mean toggling rate,
the said decrementation process comprising the following steps:
- determination of the value Q contained in the said reference field, according to the said first coding logic;
- carrying out of a decoding permutation dependent on the said value Q, of the said sequence of binary elements which is contained in the said permutation field, which is the inverse of the coding permutation;
- decrementation according to the said second coding logic of the sequence of binary elements which is obtained after the said permutation;
- if the value, according to the said second coding logic, of the decremented sequence of binary elements corresponds to the last datum of the said string, decrementation according to the said first coding logic of the sequence of binary elements which is contained in the said reference field and determination of the corresponding value Q;
- carrying out of a coding permutation dependent on the said value Q, of the said decremented sequence of binary elements which is contained in the said permutation field.
